Europäisches Patentamt

(19) European Patent Office

Office européen des brevets

(11) Veröffentlichungsnummer: **0 198 418**
**B1**

(12) **EUROPÄISCHE PATENTSCHRIFT**

(45) Veröffentlichungstag der Patentschrift: **16.08.90**

(51) Int. Cl.⁵: **H 05 K 7/14**

(21) Anmeldenummer: **86104884.1**

(22) Anmeldetag: **10.04.86**

(54) Gehäuse mit Anzeige- oder Bedienelementen zur Leiterplattenmontage.

(30) Priorität: **13.04.85 DE 3513330**

(43) Veröffentlichungstag der Anmeldung:
**22.10.86 Patentblatt 86/43**

(45) Bekanntmachung des Hinweises auf die
Patenterteilung:
**16.08.90 Patentblatt 90/33**

(84) Benannte Vertragsstaaten:
**AT CH DE GB LI**

(56) Entgegenhaltungen:
**EP-A-0 110 632**
**DE-U-7 321 756**
**DE-U-8 236 260**
**US-A-3 573 558**

**IBM TECHNICAL DISCLOSURE BULLETIN, Band
22, Nr. 4, September 1976, New York, US; C.W.
KNAPPENBERGER et al.: "Circuit board
mounting and lamp housing"**

(73) Patentinhaber: **MENTOR Ing. Dr. Paul Mozar
Otto-Hahn-Strasse 1
D-4006 Erkrath-Unterfeldhaus (DE)**

(72) Erfinder: **Weyer, Ehrhard, Dr.
Meissener Strasse 3
D-4000 Düsseldorf 12 (DE)**

(74) Vertreter: **Sparing Röhl Henseler Patentanwälte
European Patent Attorneys
Rethelstrasse 123
D-4000 Düsseldorf 1 (DE)**

## Beschreibung

Die Erfindung betrifft ein Gehäuse von im wesentlichen Quaderform aus isolierendem Material, das Anzeige-. Bedienelemente und/oder elektrische Verbindungsleitungen enthält und mit Kontakten versehen ist, die mit Leiterbahnen auf beiden Seiten einer Leiterplatte kontaktierbar sind, wobei das Gehäuse rückseitig mit einem sich über die gesamte Gehäusebreite erstreckenden Einschnitt versehen ist, in den die Leiterplatte einführbar ist, wobei die Kontakte Federkontakte sind, die beidseitig zu dem Einschnitt in Richtung auf den Einschnitt federnd angeordnet und mit den Kontaktbahnen der Leiterplatte in Eingriff bringbar sind.

Die Miniaturisierung und Perfektionierung in der Chiptechnik und integrierten Schaltungen hat dazu geführt, daß auf immer engerem Raum einer Leiterplatte immer mehr Funktionen untergebracht werden können. Der Integrationsstand konnte insbesondere noch dadurch verstärkt werden, daß Bauelemente in Oberflächenlöttechnik (SMD-Technik) mit der Leiterplatte verbunden werden. Bei letzterer wird auf Anschlußbohrungen verzichtet, während auf beiden Seiten der Leiterplatte Kontaktbahnen angeordnet werden, so daß die Möglichkeit geschaffen wird, auch die Unterseite der Leiterplatte mit Bauelementen insbesondere in Chiptechnik zu bestücken. Hieraus resultiert, daß der Platz für die frontseitige Anzeige und Bedienung immer knapper wird, zumal die geringere Höhe der Bauelemente zu einer immer dichteren Anordnung der Leiterkarten und damit zu entsprechend schmalen Frontplatten führt. Hieraus resultiert ferner das Bestreben, auch die Höhe der Anzeige- und Bedienelemente über der Leiterkarte auf ein Mindestmaß zu begrenzen.

Da die Wärmebelastung von Anzeige- oder Bedienelementen etwa beim Löten eine strapaziöse Einwirkung darstellt, die möglichst zu vermeiden ist, werden diese Elemente in Gehäusen der eingangs genannten Art untergebracht.

Aus der US—A—3 573 558 ist eine Leiterkartenhalterung in Form einer Leiste bekannt, die mittels Nieten an der Leiterkarte befestigt wird und Ausnehmungen zur Aufnahme von Gehäusen aufweist, die Betätigungs- oder Anzeigeelemente enthalten. Letztere können einen Schlitz besitzen, an dessen Innenseite Kontakte zur Kontaktierung mit der Leiterplatte münden. Die Gehäuse werden in der Leiste durch Reibschluß und durch letzteren und den Kontakteingriff mit der Leiterplatte in ihrer Position gehalten. Ein selbständiges Halten der Gehäuse an der Leiterplatte ist weder vorgesehen, noch erzielbar. Außerdem können nur solche Gehäuse verwendet werden, die in die Ausnehmungen der Leiste passen, die ihrerseits Plats beansprucht und daher den von dern Gehäusen einnehmbaren Platz einschränkt.

Aufgabe der Erfindung ist es daher, ein Gehäuse der eingangs genannten Art zu schaffen, mit dem sich möglichst platzsparend und einfach Anzeige- bzw. Bedienelemente an einer Leiterplatte montieren lassen.

Diese Aufgabe wird dadurch gelöst, daß der Einschnitt genügend tief ist, so daß das auf die Leiterplatte gesteckte Gehäuse selbsttätig hält, daß eine lösbare mechanische Verankerung für das Gehäuse an der Leiterplatte im Gehäuse im Bereich des Einschnitts vorgesehen ist und daß das mit einer bezüglich des Leiterplatteurasters genormten Gehäusebreite versehene Gehäuse mit gleichartigen Gehäusen in einer Reihe stapelbar ist.

Hierdurch wird ermöglicht, ohne den Umweg über die Oberseite der Leiterplatte, d.h. sogenannte Umsteiger, die Anzeige- und Bedienelemente so anzuordnen, daß eine Funktion oberhalb der Leiterplatte und eine weitere unterhalb der Leiterplatte liegt. Dabei ergibt sich eine optimale Verbindungsmöglichkeit, wenn der durch das Gehäuse mit den Funktionselementen gebildete Baustein rückseitig im mittleren Bereich mit dem Einschnitt versehen ist und auf die Leiterplatte so aufgeschoben werden kann, daß die Kontakte für das obere Anzeige- bzw. Bedienelement und die Kontakte für das untere Anzeige- bzw. Bedienelement beim Aufschieben auf die Leiterplatte die entsprechenden oberen und unteren Leiterbahnen kontaktieren.

Eine Vereinfachung und Kosteneinsparung ergibt sich im übrigen dadurch, daß auf der Leiterplatte keine Bohrungen für die Kontaktierung und/oder Befestigung der Gehäusekontakte bzw. Gehäuse erforderlich sind.

Andererseits ist aber die Austauschbarkeit der einzelnen Bausteine gewährleistet. Zudem brauchen sie, da es nicht notwendig ist, sie durch ein Lötbad zu führen, nicht diesbezüglich dicht (etwa gegen Lötdampfe) zu sein.

Die Kontakte können Klemmkontakte bilden. Sie können eine derartige Breite besitzen, daß sie gleichzeitig für metrische und zöllische Raster verwendbar sind, so daß entsprechende Rasterabweichungen zwischen metrischem und zöllischem Raster überbrückt werden. Die Gehäusebreite besitzt vorzugsweise eine rastermäßige Normung. Die mechanische Verankerung umfaßt insbesondere wenigstens ein federvorgespanntes Element, das eine Klemme oder Kralle, insbesondere eine Schneid-, Rast- oder Federklemme, sein kann. Das Gehäuse kann auch durch Aufpressen an der Leiterkarte befestigbar sein. Es kann mit gleichartigen Gehäusen in einer Reihe stapelbar und insbesondere zu einer auf die Leiterplatte aufsteckbaren Einheit verbindbar sein. Hierzu kann das Gehäuse mechanische Verbindungselemente an den Seitenwänden aufweisen. Eine Verbindungsleiste, die mit der Ober- oder Unterseite des Gehäuses in Eingriff bringbar ist, kann vorgesehen sein. Das Gehäuse kann leistenartig ausgebildet sein und mehrere (mehr als zwei) Anzeige- und Bedienelemente aufnehmen.

Weitere Ausgestaltungen der Erfindung sind der nachfolgenden Beschreibung und den Unteransprüchen zu entnehmen.

Die Erfindung wird nachstehend anhand der in den beigefügten Abbildungen dargestellten Ausführungsbeispiele näher erläutert.

Fig. 1 zeigt schematisch die Anordnung eines Gehäuses mit Leiterplatte.

Fig. 2 zeigt eine Draufsicht auf die Ausführungsform von Fig. 1.

Fig. 3 bis 5 zeigen schematisch verschiedene Ausführungsformen von Gehäusen in Frontansicht.

Fig. 6 und 7 zeigen schematisch im Vergleich zu Fig. 1 etwas geänderte Ausführungsformen.

Fig. 8 und 9 zeigen gestapelte Anordnungen von Gehäusen.

Fig. 10 zeigt eine perspektivische Rückansicht eines Gehäuses nach Fig. 1.

Fig. 11 bis 14 zeigen verschiedene mechanische Verankerungen für Gehäuse.

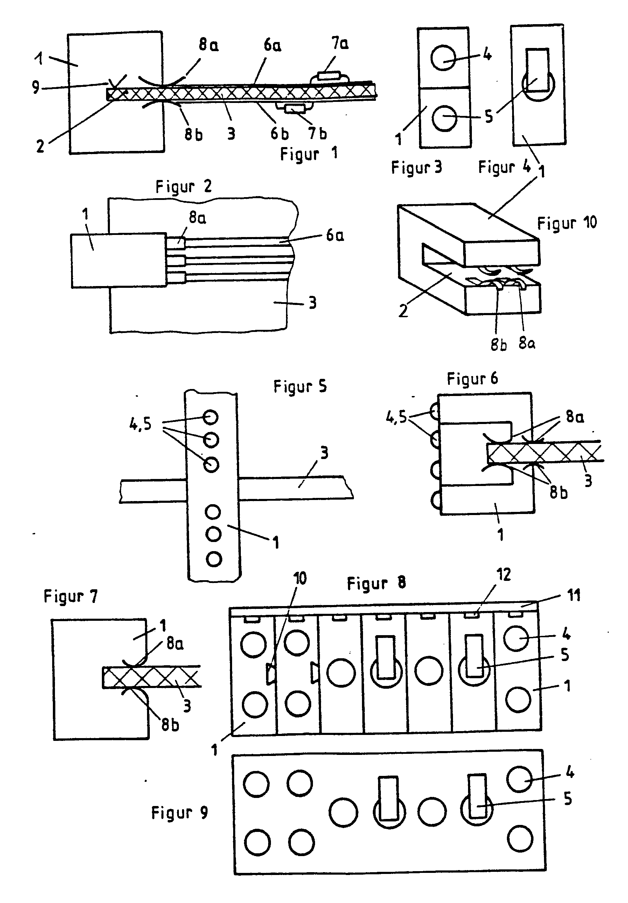

Gemäß der in den Fig. 1 und 2 dargestellten Ausführungsform ist ein im wesentlichen quaderförmiges Gehäuse 1 aus isolierendem Material, insbesondere Kunststoff, mit einem sich über die gesamte Gehäusebreite erstreckenden und mittig an der Rückseite des Gehäuses 1 angeordneten Einschnitt 2, der im Schnitt rechteckig ist und dessen Breite praktisch der Stärke einer Leiterplatte 3 entspricht, versehen. Der Einschnitt 2 ist genügend tief, so daß das auf die Leiterplatte 3 gesteckte Gehäuse 1 insoweit selbsttätig, d.h. praktisch ohne zu wackeln, hält, d.h. daß die Tiefe des Einschnitte 2 im Vergleich zur Stärke der Leiterplatte 3 groß (ein Mehrfaches hiervon) ist.

Das Gehäuse 1 besitzt frontseitig Anzeige- und/oder Bedienelemente 4, 5, beispielsweise Leuchtdioden, Lampen, Schalt- und Prüfbuchsen, Drucktaster, Schalter, Kippschalter, Taster, Potentiometer, Sicherungshalter o.dgl. Die Gehäuse 1 können gegebenenfalls auch an ihrer Oberseite mit Anzeige- und/oder Bedienelementen 4, 5 für die Ober- bzw. Unterseite der Leiterplatte 3 versehen sein. Außerdem ist es möglich, die Gehäuse 1 zur Aufnahme von Verbindungsleitungen zum Herstellen von elektrischen Verbindungen zwischen der Ober- und Unterseite der Leiterplatte 3 ohne die Notwendigkeit von Kontaktierungsbohrungen zu verwenden. Die Gehäuse 1 können auch Umschaltelemente zum Umschalten zwischen Ober- und Unterseite der Leiterplatte 3 aufnehmen. Gemäß Fig. 9 kann das Gehäuse 1 leistenartig ausgebildet sein und eine Mehrzahl von Bedien- bzw. Anzeigeelementen aufnehmen.

Die Leiterplatte 3 besitzt ober- und unterseitig Leiterbahnen 6a bzw. 6b und Leiterplattenbauelemente 7a bzw. 7b. Das Gehäuse 1 ist mit dem Einschnitt 2 auf den Vorderkantenbereich der Leiterplatte 3 aufgesteckt, wobei sich aus dem Gehäuse 1 im Bereich des Einschnitts 2 herausstreckende obere und untere Federkontakte 8a bzw. 8b beim Aufschieben des Gehäuses 1 auf die Leiterplatte 3 deren Leiterbahnen 6a bzw. 6b federnd kontaktieren. Im Bereich des Einschnitts 2 sind entsprechende Ausnehmungen im Gehäuse 1 vorgesehen, in die die klemmenden Federkontakte 8a, 8b münden. Die Kontaktfüße können sowohl nach außen als auch nach innen (Fig. 7) gerichtet sein, wobei letzteres insbesondere bei gestaffelter Anordnung innerhalb des Einschnitts 2 (Fig. 6) zweckmäßig ist.

Ferner ist eine lösbare mechanische Verankerung 9 für das Gehäuse 1 an der Leiterplatte 3 im Bereich des Einschnitts 2 vorgesehen.

Die Gehäuse 1 und die Federkontakte 8a, 8b sind auf das Leiterplattenraster, beispielsweise metrisch oder 19'', abgestimmt und letztere können insbesondere eine derartige Breite besitzen, daß sie gleichzeitig für metrische und zöllische Raster verwendbar sind.

Wie aus Fig. 8 ersichtlich, sind die dort dargestellten Gehäuse 1 miteinander über eine Schwalbenschwanzverbindung 10 an benachbarten Seitenwänden nebeneinander stapel- und verbindbar ausgebildet. Statt der Schwalbenschwanzverbindung kann auch eine Nut/Stegoder Druckknopfverbindung, Kleben, Haftkleben o.dgl. verwendet werden.

Die Gehäuse 1 können ferner über eine Verbindungsleiste 11 und/oder unterseitig miteinander verbunden werden, so daß sie auch diese Weise komplett auf die Leiterplatte 3 aufgeschoben werden können. Die Verbindungsleiste 11 kann auch dazu verwendet werden, die Gehäuse 1 auf unterschiedliche Raster zu bringen. Die Verbindungsleiste 11 kann Positionierzapfen 12 aufweisen, die mit entsprechenden Ausnehmungen an den Gehäusen 1 in Eingriff bringbar sind, was eine exakte Rasteranordnng gewährleistet.

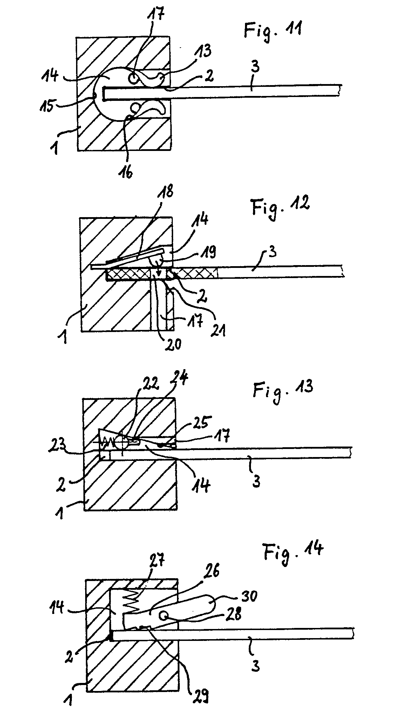

Die lösbare mechanische Verankerung 9 kann gemäß Fig. 11 aus Schneidklemmen 13 bestehen, die paarweise in dem Gehäuse 1 angeordnet und in einem Abstand kleiner als die Stärke der Leiterplatte 3 federnd in einer entsprechenden Ausnehmung 14 des Gehäuses 1 beidseitig in den Bereich des Einschnitts 2 ragend angeordnet sind. Das oder jedes Paar von Schneidklemmen 13 ist aus einem in die Ausnehmung 14 eingesetzten gebogenen Blechstreifen 15 gebildet, der sich mit seiner flachen Seite im Gehäuse 1 abstützt und durch Schultern 16 gehalten wird, während die in die Darstellungsebene von Fig. 11 um 90° gebogenen freien Schenkel hiervon die Schneidklemmen 13 bilden. Durch das Aufschieben des Gehäuses 1 auf die Leiterplatte 3 werden die Schneidklemmen 13 auseinandergebogen und schneiden beim weiteren Aufschieben in die Leiterplatte 3 ein, um auf diese Weise eine Klemmkraft auszuüben. Zum Lösen ist jeweils ein Loch 17 im Bereich jeder Schneidklemme 13 senkrecht zur Aufschubrichtung des Gehäuses 1 vorgesehen, durch die ein Werkzeug eingeführt werden kann, mit dem die Schneidklemmen 13 entgegen ihrer Federvorspannung auseinandergedrückt werden.

Bei der in Fig. 12 dargestellten mechanischen Verankerung 9 handelt es sich um eine Rastklemme 18, die einen Rastvorsprung 19 aufweist, der mit einer entsprechenden Rastöffnung 20 in der Leiterplatte 3 in Eingriff bringbar ist. Die Rastklemme 18, die einstückig mit dem Gehäuse 1 ausgebildet oder in dieses eingesetzt sein kann, ist in Richtung auf den Einschnitt 2 federvorgespannt. Durch das Aufschieben des Gehäuses 1 auf die Leiterplatte 3 wird die Rastklemme 18 gegen die Federvorspannung ausgelenkt und der Rastvorsprung 19 gleitet über die Leiterplatte 3, bis er infolge seiner Federvorspannung in die Rastöffnung 20 einrastet. Eine Anschrägung 21 des Einschnitts 2 an der Seite, auf die die Rastklemme 18 vorgespannt ist, erleichtert das Einführen der Leiterplatte in den Einschnitt 2 unter die Rastklemme 18. Eine Bohrng 17 dient zum Entrasten mittels eines Werkzeugs.

Bei der in Fig. 13 dargestellten Ausführungsform ist die mechanische Verankerung 9 eine Federklemme bestehend aus einer Rolle 22 und einer Feder 23, eine Schrauben-, Draht- oder insbesondere Blattfeder, wobei die Ausnehmung 14 im Schnitt dreieckig ist. Die Achse der Rolle 22 ist beidseitig in einem Langloch 24 parallel zum Einschnitt 2 geführt. Diese Führung dient dazu, die Rolle 22 in der Ausnehmung 14 zu halten. Durch Aufschieben des Gehäuses 1 auf die Leiterplatte 3 wird zunächst die Rolle 22 in Richtung zur Frontseite des Gehäuses 1 entgegen der Federvorspannung gedrückt. Die Rolle 22 gelangt mit der entsprechenden Ober- oder Unterseite der Leiterplatte 3 in Eingriff und übt auf die Leiterplatte 3 eine Klemmwirkung aus, da die Feder 23 die Rolle 22 gegen die Schrägfläche 25, die die Ausnehmung 14 begrenzt, drückt. Über eine Bohrung 17 ist ein Werkzeug einführbar, das die Rolle 22 lösen und damit die Klemmwirkung aufheben kann.

Bei der in Fig. 14 dargestellten Ausführungsform ist die mechanische Verankerung 9 eine Kralle 6, die in Richtung auf den Einschnitt 2 mittels einer Feder 27 in der Ausnehmung 14 vorgespannt und um eine Achse 28 drehbar angeordnet ist. Widerhakenartige Fortsätze 29 bilden die Verankerung mit der Leiterplatte 3. Ein aus dem Gehäuse 1 rückseitig herausragender Abschnitt 30 der Kralle 26 kann zum Lösen der Kralle entgegen der Federvorspannung manuell betätigt werden. Die Kralle 26 kann sich aber auch ingesamt im Gehäuse 1 befinden, während über eine von der Oberseite des Gehäuses 1 zur Ausnehmung 14 geführte Bohrung das Einführen eines Werkzeugs zum Lösen der Kralle 26 ermöglicht.

## Patentansprüche

1. Gehäuse von im wesentlichen Quaderform aus isolierendem Material, das Anzeige-, Bedienelemente (4, 5) und/oder elektrische Verbindungsleitungen enthält und mit Kontakten (8a, 8b) versehen ist, die mit Leiterbahnen (6a, 6b) auf beiden Seiten einer Leiterplatte (3) kontaktierbar sind, wobei das Gehäuse rückseitig mit einem sich über die gesamte Gehäusebreite erstreckenden Einschnitt (2) versehen ist, über den es auf die Leiterplatte (3) aufsteckbar ist, wobei die Kontakte (8a, 8b) Federkontakte sind, die beidseitig zu dem Einschnitt (2) in Richtung auf den Einschnitt (2) federnd angeordnete und mit den Kontaktbahnen (6a, 6b) der Leiterplatte (3) in Eingriff bringbar sind, dadurch gekennzeichnet, daß der Einschnitt (2) gegenügend tief ist, so daß das auf die Leiterplatte (3) gesteckte Gehäuse selbsttätig hält, daß eine lösbare mechanische Verankerung (9) für das Gehäuse an der Leiterplatte (3) im Gehäuse im Bereich des Einschnitts (2) vorgesehen ist und daß das mit einer bezüglich des Leiterplattenrasters genormten Gehäusebreite versehene Gehäuse mit gleichartigen Gehäusen in einer Reihe stapelbar ist.

2. Gehäuse nach Anspruch 1, dadurch gekennzeichnet, daß die Anzeige- und Bedienelemente (4, 5) so angeordnet sind, daß eine Funktion oberhalb und eine weitere unterhalb der Leiterplatte (3) liegt, während der Einschnitt (2) etwa im mittleren Bereich des Gehäuses angeordnet ist.

3. Gehäuse nach Anspruch 1 oder 2, dadurch gekennzeichnet, daß die Kontakte (8a, 8b) Klemmkontakte bilden.

4. Gehäuse nach einem der Ansprüche 1 bis 3, dadurch gekennzeichnet, daß die Kontakte (8a, 8b) eine derartige Breite besitzen, daß sie gleichzeitig für metrische und zöllische Raster verwendbar sind.

5. Gehäuse nach einem der Ansprüche 1 bis 4, dadurch gekennzeichnet, daß die Gehäusebreite eine rastermäßige Normung besitzt.

6. Gehäuse nach einem der Ansprüche 1 bis 5, dadurch gekennzeichnet, daß die mechanische Verankerung (9) wenigstens ein federvorgespanntes Element (13, 18, 22, 26) umfaßt.

7. Gehäuse nach Anspruch 6, dadurch gekennzeichnet, daß das federvorgespannte Element (13, 18, 22, 26) eine Klemme oder Kralle, insbesondere eine Schneid-, Rast- oder Federklemme, ist.

8. Gehäuse nach einem der Ansprüche 1 bis 5, dadurch gekennzeichnet, daß es durch Aufpressen an der Leiterkarte (3) befestigbar ist.

9. Gehäuse nach einem der Ansprüche 1 bis 8, dadurch gekennzeichnet, daß es mit gleichartigen Gehäusen in einer Reihe stapelbar und insbesondere zu einer auf die Leiterplatte (3) aufsteckbaren Einheit verbindbar ist.

10. Gehäuse nach Anspruch 9, dadurch gekennzeichnet daß mechanische Verbindungselemente (10) an den Seitenwänden vorgesehen sind.

11. Gehäuse nach einem der Ansprüche 1 bis 10, dadurch gekennzeichnet, daß eine Verbindungsleiste (11), die mit der Ober- oder Unterseite des Gehäuses in Eingriff bringbar ist, vorgesehen ist.

12. Gehäuse nach einem der Ansprüche 1 bis 10, dadurch gekennzeichnet, daß es leistenartig ausgebildet ist und mehrere Anzeige- und Bedienelemente (4, 5) aufnimmt.

## Revendications

1. Boîtier en un matériau isolant présentant une forme générale parallélépipédique comprenant des éléments (4, 5) d'affichage, de commande et/ou des connexions électriques et muni de contacts (8a, 8b) qui peuvent être mis en contact avec des pistes conductrices (6a, 6b) sur les deux faces d'une plaque de circuit imprimé (3), le boîtier étant muni, à l'arrière, d'une fente (2) s'étendant sur l'ensemble de la largeur du boîtier (2) par laquelle il peut être enfiché sur la plaque de circuit imprimé (3), les contacts (8a, 8b) étant

des contacts élastiques disposés des deux côtés de la fente (2) en faisant ressort dans la fente (2) et pouvant être amenés en contact avec les pistes conductrices (6a, 6b) de la plaque de circuit imprimé (3), caractérisé en ce que la fente (2) est suffisamment profonde pour que le boîtier enfiché sur la plaque du circuit imprimé (3) tienne de lui-même, en ce qu'un dispositif de maintien mécanique démontable (9) du boîtier sur la plaque de circuit imprimé (3) est prévu dans le boîtier dans la zone de la fente (2) et en ce que le boîtier, ayant une largeur de boîtier normalisée par rapport à la grille des plaques de circuit imprimé, est juxtaposable en une rangée avec des boîtiers semblables.

2. Boîtier selon la revendication 1, caractérisé en ce que les éléments d'affichage et de commande (4, 5) sont disposés de sorte qu'une fonction se trouve en dessus de la plaque de circuit imprimé (3) et une autre en dessous, la fente (2) étant ménagée dans la zone médiane du boîtier.

3. Boîtier selon la revendication 1 ou 2, caractérisé en ce que les contacts (8a, 8b) forment des contacts de serrage.

4. Boîtier selon l'une des revendications 1 à 3, caractérisé en ce que les contacts (8a, 8b) présentent une largeur telle qu'ils peuvent être utilisés aussi bien avec une grille métrique, qu'avec une grille en mesures anglaises.

5. Boîtier selon l'une des revendications 1 à 4, caractérisé en ce que la largeur du boîtier est normée sur la grille.

6. Boîtier selon l'une des revendications 1 à 5, caractérisé en ce que le dispositif de maintien mécanique (9) comprend au moins un élément (13, 18, 22, 26) sollicité élastiquement.

7. Boîtier selon la revendication 6, caractérisé en ce que l'élément (13, 18, 22, 26) sollicité élastiquement est une pince ou une griffe en particulier une pince à incisions, à encliquetage, ou à élasticité.

8. Boîtier selon l'une des revendications 1 à 5, caractérisé en ce qu'il peut être fixé sur la plaque de circuit imprimé (3) par engagement par pression.

9. Boîtier selon l'une des revendications 1 à 8, caractérisé en ce qu'il peut être juxtaposé en une rangée à des boîtiers semblables et en particulier en ce qu'il peut être relié avec une unité enfichable sur la plaque de circuit imprimé (3).

10. Boîtier selon la revendication 9, caractérisé en ce que des éléments de liaison mécaniques (10) sont prévus sur les parois latérales.

11. Boîtier selon l'une des revendications 1 à 10, caractérisé en ce qu'il est prévu une barre de liaison (11) qui peut être amenée en prise avec la face supérieure ou inférieure du boîtier.

12. Boîtier selon l'une des revendications 1 à 10, caractérisé en ce qu'il présente la forme d'une barre et en ce qu'il contient plusieurs éléments (4, 5) d'affichage et de commande.

## Claims

1. A substantially block-shaped housing made of insulating material and containing indicator elements, controls (4, 5) and/or electrical connecting leads, and having contacts (8a, 8b) adapted to make contact with printed conductors (6a, 6b) on both sides of a printed circuit board (3), the back of the housing being formed with an incision (2) which extends over the entire housing width and by means of which it can be pushed on to the printed circuit board (3), the contacts (8a, 8b) being spring contacts arranged on either side of the incision (2) so as to be spring biased in the direction of the incision (2) and engageable with the contact conductors (6a, 6b) of the printed circuit board (3), characterised in that the incision (2) is sufficiently deep so that the housing fitted on to the printed circuit board (3) holds automatically, in that a releasable mechanical anchorage (9) for the housing on the printed circuit board (3) is provided in the housing in the region of the incision (2), and in that the housing, the width of which is standardised with respect to the printed circuit board reference grid, is stackable in a row together with identical housings.

2. A housing according to claim 1, characterised in that the indicator elements and controls (4, 5) are so disposed that one function is situated above and another function below the printed circuit board (3), while the incision (2) is disposed approximately in the middle region of the housing.

3. A housing according to claim 1 or 2, characterised in that the contacts (8a, 8b) form clamping contacts.

4. A housing according to any one of claims 1 to 3, characterised in that the contacts (8a, 8b) have a width such that they can be used simultaneously for metric and inch-scale reference grids.

5. A housing according to any one of claims 1 to 4, characterised in that the housing width is a standard reference grid dimension.

6. A housing according to any one of claims 1 to 5, characterised in that the mechanical anchorage (9) comprises at least one spring-biased element (13, 18, 22, 26).

7. A housing according to claim 6, characterised in that the spring-biased element (13, 18, 22, 26) is a clamp or claw, more particularly a cutting clamp, a catch or a spring clip.

8. A housing according to any one of claims 1 to 5, characterised in that it can be secured by pressing it on to the printed circuit board (3).

9. A housing according to any one of claims 1 to 8, characterised in that it is stackable in a row with identical housings and is adapted to be connected more particularly to form a unit which can be pushed on to the printed circuit board (3).

10. A housing according to claim 9, characterised in that mechanical connecting elements (10) are provided on the side walls.

11. A housing according to any one of claims 1 to 10, characterised in that a connecting strip (11) is provided which is engageable with the top or bottom of the housing.

12. A housing according to any one of claims 1 to 10, characterised in that it is formed as a strip and accommodates a plurality of indicator elements and controls (4, 5).

Figur 1

Figur 2

Figur 3

Figur 4

Figur 10

Figur 5

Figur 6

Figur 7

Figur 8

Figur 9

EP 0 198 418 B1

Fig. 11

Fig. 12

Fig. 13

Fig. 14

2